# EUROPEAN PATENT APPLICATION

(11) **EP 4 498 051 A1**
(43) Date of publication of application: **29.01.2025**
(21) Application number: 23167728.7
(22) Date of filing: 13.04.2023
(51) Int. Cl.: G01J 5/20, G01J 5/02

(54) **THERMAL SENSOR DEVICE AND METHOD OF MANUFACTURE THEREOF**

(71) Applicant: Melexis Technologies NV, 3980 Tessenderlo (BE)
(72) Inventor: CHEN, Jian, 3980 Tessenderlo (BE); VAN BUGGENHOUT, Carl, 8900 Ieper (BE); PETROPOULOS, Anastasios, 3980 Tessenderlo (BE)
(74) Representative: Kay, Ross Marcel

(57) **Abstract**

A thermal sensor device (100) comprises an integrated circuit die (104) having a first mating side (126) and an external side (128) opposite the mating side (126). A sensor-containing die (102) is disposed in spaced relation with the integrated circuit die (104) so that the first mating side (126) faces a second mating side (114), a portion (144) of the sensor-containing die (102) overhanging the integrated circuit die (104). An electrically conductive circuit path (132, 146, 120, 122) extends from a first opposing surface (134) of the first mating side (126) to a second opposing surface of the second mating side (114) and extends further to the overhanging portion (144) so that a portion of the electrically conductive circuit path (132, 146, 120, 122) also overhangs the integrated circuit die (104). An electrical linkage portion (148) electrically couples to the electrically conductive circuit path (132, 146, 120, 122) at the overhanging portion (144) and extends beyond the external side (128) of the integrated circuit die (104).

## Description

The present invention relates to a thermal sensor device of the type that, for example, comprises a first die having a thermal sensor formed therein coupled to a second die having an integrated circuit formed therein. The present invention also relates to a method of manufacturing a thermal sensor device, the method being of the type that, for example, couples a first wafer having a thermal sensor formed therein to a die having an integrated circuit formed therein.

In the field of thermal sensors, device structures can be formed out of silicon and other materials that respond to heat in order to generate an electrical signal that can be used to measure temperature, sometimes at a distance from the device. One known thermal sensor device design employs a die, for example a MicroElectroMechanical Systems (MEMS) sensor die formed with a thermal sensor element therein. The thermal sensor, when in use, receives electromagnetic radiation in the infra-red range of the electromagnetic spectrum and translates the infra-red electromagnetic radiation to an electrical signal. Typically, the thermal sensor element can have a thermopile sensor structure or a microbolometer sensor structure.

In order to make use of the electrical signal generated by the thermal sensor element for providing temperature measurements, it is necessary to process the electrical signal. Some pre-processing or signal conditioning may be provided by on-board electrical circuitry of the sensor die, but further processing is typically required beyond the practical limitations that can be provided on the sensor die. Consequently, it is known to provide an additional die comprising an integrated circuit in order to receive electrical signals output by the sensor element on the sensor die, either raw or pre-processed, and to process the received signals in order to calculate a temperature of the sensor element. This integrated circuit die is known to be mated in relatively close proximity with the sensor die, for example as described in US patent publication no. 2014/306312 A1. This document describes a MEMS sensor package comprising a MEMS sensing die having a sensor device formed therein and a so-called readout Integrated Circuit (IC) die. The sensing die and the readout IC die are connected together using soldered connections in order to communicate electrical signals from the sensor die to the readout IC die. Joint solders are formed around the periphery of the dies in order to create a seal between the dies. However, in order to communicate the electrical signals, for example measurement data, from the readout IC die and indeed certain electrical signals to the readout IC die in order to control the sensor die, Through-Silicon Vias (TSVs) have to be formed through the readout IC die in order to provide electrical signal contacts for connection to, for example, a circuit board. The formation of TSVs adds complexity and cost to the manufacture of the sensor device. Additionally, the provision of solder to the backside of the readout IC die, where ends of the TSVs are located, also serves to add height to the device.

According to a first aspect of the present invention, there is provided a thermal sensor device comprising: an integrated circuit die having a first device assembly mating side and an external side opposite the device assembly mating side; a sensor-containing die disposed in spaced relation with the integrated circuit die so that the first device assembly mating side of the integrated circuit die faces a second device assembly mating side of the sensor-containing die, a portion of the sensor-containing die overhanging the integrated circuit die; an electrically conductive circuit path extending from a first opposing surface of the first device assembly mating side of the integrated circuit die to a second opposing surface of the second device assembly mating side of the sensor-containing die and extending further to the overhanging portion of the sensor-containing die so that a portion of the electrically conductive circuit path also overhangs the integrated circuit die; and an electrical linkage portion electrically coupled to the electrically conductive circuit path at the overhanging portion of the sensor-containing die and extending beyond the external side of the integrated circuit die.

The sensor-containing die may also comprise a scene-ward side provided opposite the second device assembly mating side of the sensor-containing die; wherein the scene-ward side may be configured to receive infrared electromagnetic radiation.

The device may further comprise: a continuous sealing layer disposed as a loop and sealingly contacting the first opposing surface and the second opposing surface; wherein the first and second opposing surfaces together with the continuous sealing layer may define an internal volume.

The electrically conductive circuit path may extend from the first opposing surface to the second opposing surface from within the internal volume.

The electrically conductive circuit path may extend further to the overhanging portion of the sensor-containing die through the sensor-containing die.

The internal volume may be pressurised.

A vacuum may be maintained in the internal volume. The pressure within the internal volume may be less than 1 mbar. The pressure within the internal volume may be greater than or equal to 1 mbar.

The device may further comprise: a first passivation layer disposed on the first device assembly mating side of the integrated circuit die.

The first passivation layer may comprise first locator apertures formed therein.

The device may further comprise: a second passivation layer disposed on the second device assembly mating side of the sensor-containing die.

The second passivation layer may comprise second locator apertures formed therein.

The device may further comprise: a reflective layer configured to reflect infra-red electromagnetic radiation; the reflective layer may be disposed on the first device assembly mating side of the integrated circuit die.

The device may further comprise: a layer of getter material disposed on the first device assembly mating side of the integrated circuit die.

The sensor-containing die may comprise a lens.

The sensor-containing die may comprise an optical filter.

The integrated circuit die may be separated from the sensor-containing die by a separation distance; the separation distance may be a function of a central wavelength of expected incident infrared electromagnetic radiation.

The separation distance may be between about 1.5µm and about 4µm, for example about 2.5µm.

The sensor-containing die may comprise a thermopile thermal sensor element or a microbolometer thermal sensor element.

The integrated circuit die may comprise an integrated circuit configured to measure a temperature of the thermal sensor element.

According to a second aspect of the present invention, there is provided a method of manufacturing a thermal sensor device, the method comprising: forming an integrated circuit die having a first device assembly mating side and an external side opposite the device assembly mating side; forming a sensor-containing wafer comprising a candidate sensor-containing die; disposing the integrated circuit die opposite the sensor-containing wafer in spaced relation thereto so that the first device assembly mating side of the integrated circuit die faces a second device assembly mating side of the candidate sensor-containing die of the sensor-containing wafer, a portion of the candidate sensor-containing die of the sensor-containing wafer overhanging the integrated circuit die; forming an electrically conductive circuit path that extends from a first opposing surface of the first device assembly mating side of the integrated circuit die to a second opposing surface of the second device assembly mating side of the candidate sensor-containing die and extends further to the overhanging portion of the candidate sensor-containing die so that a portion of the electrically conductive circuit path also overhangs the integrated circuit die; and extending the electrically conductive circuit path further by coupling an electrical linkage portion electrically to the overhanging portion of the candidate sensor-containing die so that the electrical linkage portion extends beyond the external side of the integrated circuit die.

It is thus possible to provide a thermal sensor device of reduced complexity and to provide a method of manufacturing a thermal sensor device having processing steps of reduced complexity, thereby reducing manufacturing costs. The overall height of the thermal sensor device is also reduced, which is beneficial for certain applications where a product containing the thermal sensor device may have limited space to site the thermal sensor device. Furthermore, the thermal sensor device and method of manufacture therefor supports a modular approach, allowing the integrated circuit die and the sensor-containing die to each be developed independently, thereby providing greater design flexibility. Additionally, as compared with wafer bonding techniques where two wafers are simply bonded together, the method of manufacture set forth herein allows pairings of integrated circuit dies and the sensor-containing dies, thereby avoiding coupling of a faulty sensor-containing die to a fault-free integrated circuit die and vice versa.

At least one embodiment of the invention will now be described, by way of example only, with reference to the accompanying drawings, in which:
**Figure 1** is a schematic diagram of a thermal sensor device constituting an embodiment of the invention;
**Figure 2** is a flow diagram of a method of manufacturing an integrated circuit die of the thermal sensor device of Figure 1; and
**Figures 3(a) to (d)** are schematic diagrams of progressive latter stages of fabrication of the integrated circuit die according to the method of Figure 2;
**Figure 4** is a flow diagram of a method of fabricating the thermal sensor device of Figure 1 using the integrated circuit die of Figure 3(d) and constituting another embodiment of the invention;
**Figure 5** is a schematic diagram of progressive latter stages of fabrication of a thermal sensor wafer in accordance with the method of Figure 4 and used to form the thermal sensor device of Figure 1; and
**Figure 6** is a schematic diagram of progressive stages of assembly of the thermal sensor device of Figure 1 in accordance with the method of Figure 4.

Throughout the following description, identical reference numerals will be used to identify like parts.

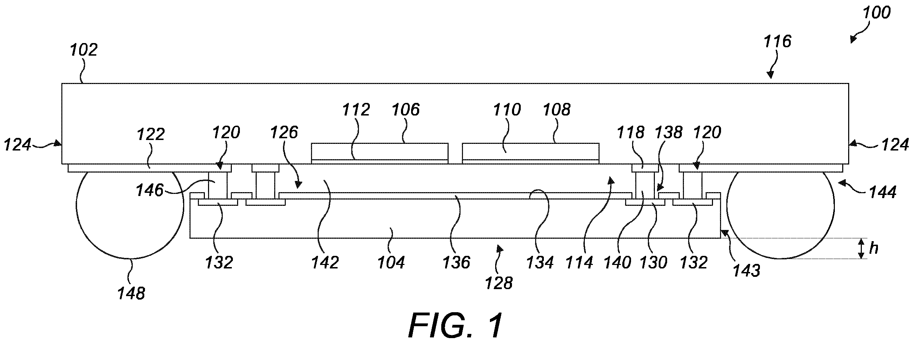

Referring to Figure 1, a thermal sensor device 100 comprises a thermal sensor die 102 coupled to an integrated circuit die 104. The thermal sensor die 102 is formed from a (Micro ElectroMechanical Systems) MEMS wafer and comprises a first infrared sensor 106 and a second infrared sensor 108, the thermal sensor die 102 being formed from a substrate material capable of being transmissive to at least infrared electromagnetic radiation. In this example, the first and second infrared sensors 106, 108 are neighbouring windowed and windowless thermal sensing elements, known as "live" and "blind" pixels, respectively. The live pixels comprise apertures in cap portions thereof to receive infrared radiation emitted by objects in a scene and constitute measurement sensor pixels, whereas blind pixels intentionally do not possess such apertures and are used, for example, for reference purposes. In this example, the first and second infrared sensors 106, 108 are of the thermocouple sensor kind, but the use of other thermal sensing technology is contemplated, for example the first and second infrared sensors 106, 108 can be microbolometers. Although two infrared sensors are described herein, the skilled person will appreciate that the number of infrared sensors provided in the thermal sensor die 102 can vary and a greater or smaller number of thermal sensors can be employed, for example a single thermal sensor or three or four thermal sensors. Indeed, the thermal sensor die 102 can comprise an array of thermal sensors or clusters of sensors, for example a 32 x 48 array of thermal sensors.

In the present example, the first and second thermal sensors 106, 108 respectively each comprise a cavity 110 and a thermal sensor element 112. In the case of a thermocouple sensor, the thermal sensor element 112 comprises beams from which a membrane is suspended over the cavity 110 and thermocouples integrated into the beams and membrane. However, as mentioned above, other technologies and/or configurations can be employed.

The thermal sensor die 102 therefore constitutes a sensor-containing substrate and has a device assembly mating side 114 and an external or scene-facing or scene-ward side 116 located opposite the device assembly mating side 114. Optionally, lenses (not shown) can be provided on the scene-ward side 116 to focus infra-red electromagnetic radiation better to the first and second thermal sensors 106, 108. Similarly, performance can be enhanced by providing one or more optical filter on or in the thermal sensor die 102. The thermal sensor die 102 comprises a first peripheral contact region 118 and one or more first signal contact regions 120. In relation to the first signal contact region or regions 120, an electrically conductive circuit path is provided and comprises an extending portion of metallisation 122 that extends towards a periphery 124 of the thermal sensor die 102. The electrically conductive circuit path comprises other electrically conductive regions, details of which will be described later herein.

The integrated circuit die 104 is, in this example, a Complementary Metal Oxide Semiconductor (CMOS) die and comprises an integrated circuit integrally formed therewith (not shown) configured, inter alia, to measure a temperature or temperatures of the first and second thermal sensors 106, 108 of the thermal sensor die 102. The integrated circuit die 104 comprises another device assembly mating side 126 and an external side 128 opposite the device assembly mating side 126, the thermal sensor device 100 being electrically connected, for example, to a printed circuit board (not shown) at the external, or board-facing, side 128.

The integrated circuit die 104 also comprises a second peripheral contact region 130 on the device assembly mating side 126 thereof and is disposed opposite and in registry with the first peripheral contact region 118 and serves as a counterpart to the first peripheral contact region 118. In this regard, the thermal sensor die 102 is disposed in spaced relation with the integrated circuit die 104 so that the device assembly mating side 114 of the thermal sensor die 102 is opposite and faces the device assembly mating side 126 of the integrated circuit die 104. In this regard, a separation distance exists between the thermal sensor die 102 and the integrated circuit die 104, the separation distance being selected as a function of a central wavelength of expected incident infra-red electromagnetic radiation by the thermal sensor device 100. The separation distance is, for example, calculated as about one quarter of the wavelength of the electromagnetic radiation that the thermal sensor die 102 is intended to detect. In this example, the separation distance may be between about 1.5 *µ*m and about 4 *µ*m, for example about 2.5 *µ* m, which translates to a target received wavelength of about 10 *µ*m.

The integrated circuit die 104 also comprises one or more second signal contact regions 132 on the device assembly mating side 126 thereof for respectively coupling electrically to the first signal contact region or regions 120. In this regard, the second contact region or regions 132 are disposed opposite and in registry with first signal contact region or regions 120, respectively.

The integrated circuit die 104 has an active semiconductor surface 134 on the device assembly mating side 126 thereof, a first passivation layer 136 overlying the active semiconductor surface 134. The first passivation layer 136 serves to reduce outgassing, i.e. serves as a getter, from the materials of the integrated circuit die 104, the first passivation layer 136 being exposed in regions 138 corresponding to where a connection is to be formed with corresponding contact regions 118, 120 of the thermal sensor die 102, thereby comprising first locator apertures. However, the first passivation layer 136 also acts as a barrier to molecules being outgassed from the integrated circuit die 104. Furthermore, the first passivation layer 136 behaves as a reflector when in use to reflect infrared electromagnetic radiation that propagates through the thermal sensor die 102 back to the thermal sensor die 102, thereby improving detection efficiency.

A peripheral wall 140 formed, for example, from solder extends between the first peripheral contact region 118 and the second peripheral contact region 130 so as to sealingly define a chamber between the thermal sensor die 102 and the integrated circuit die 104, the chamber 142 having an internal volume. In this example, an internal cavity pressure, is maintained in the chamber 142 and constitutes an internal gas, for example, a mixture of certain respective partial pressures of the constituent gas species or molecules, which together define the internal cavity pressure of the chamber 142. In one example, the internal cavity pressure can be a vacuum, for example less than about 1mbar, or even less than about 0.1mbar, or even less than about 0.01mbar, which can beneficially reduce unwanted thermal heat flows within the chamber 142. In another example, the internal cavity pressure can be about 1mbar or more, for example about 10mbar or about 100mbar or about 300mbar or about 1bar or greater, in order to increase the robustness of the thermal sensor device 100 against pressure drifts. Indeed, the higher the internal cavity pressure, the less dependent the thermal sensor device 100 becomes upon small pressure changes due to leak rate, which is a function of the pressure of the pressure difference between the chamber 142 and the ambient.

The peripheral wall 140 is, in this example, disposed as a loop and constitutes a continuous sealing layer that sealingly contacts the first peripheral contact region 118 and the second peripheral contact region 130.

The periphery 124 of the thermal sensor die 102 extends, at least in part, beyond a periphery 143 of the integrated circuit die 104 so that a portion 144 of the thermal sensor die 102 overhangs the integrated circuit die 104.

One or more electrical bridging connections 146 formed, for example, from solder respectively extend from the first signal contact region or regions 120 to the one or more second signal contact regions 132. As such, the electrically conductive circuit path described above also comprises the second signal contact region or regions 132 and the one or more electrical bridging connections 146 so that the electrically conductive circuit path extends from the second signal contact region or regions 132 of the integrated circuit die 104 and hence a first opposing surface of the device assembly mating side 126 of the integrated circuit die 104 to a second opposing surface of device assembly mating side 114 of the thermal sensor die 102, and the electrically conductive circuit path extends further to the overhanging portion 144 of the thermal sensor die 102 via the extending portion of metallisation 122. A part of the electrically conductive circuit path therefore also overhangs the integrated circuit die 104.

In order to provide connection of the integrated circuit die 104 and/or the thermal sensor die 102 to a circuit board, an electrical linkage portion 148, for example a solder ball, is thermally adhered to the overhanging portion of the electrically conductive circuit path, for example to the extending portion of metallisation 122. In this example, the diameter of the electrical linkage portion 148 is between about 250 *µ*m and about 500 *µ*m. The electrical linkage portion 148 is dimensioned so as to extend beyond a surface of the integrated circuit die 104 on the external side 128 thereof, for example by a distance, h, to provide sufficient conductive material to solder to the circuit board and maintain an electrical connection to the extending portion of metallisation 122. Furthermore, it is desirable for the distance, h, to be sufficiently large that a clearance exists between the external side 128 of the integrated circuit die 104 and he circuit board following a Surface-Mount Technology (SMT) assembly of the thermal sensor device 100 onto the circuit board.

Provision of electrical connections between the thermal sensor die 102 and the integrated circuit die 104 supports, for example, the reception by the integrated circuit die 104, when in use, of analogue signals corresponding to infrared electromagnetic radiation received by the first and second thermal sensors 106, 108 via the scene-ward side 116 of the thermal sensor die 102, so that calculations can be performed using the received signals in order to provide a temperature value using any suitable method, for example as described in European patent publication no. EP-A1-3 745 104. The received signals can be amplified by the integrated circuit die 104, and then converted to the digital domain using signal processing circuitry provided by the integrated circuit die 104, for example Analogue-to-Digital Converter (ADC) circuitry. In other examples, amplification can be performed by the thermal sensor dies 102 if the thermal sensor die 102 is fabricated using CMOS technology. The value calculated can then be output from the thermal sensor device 100 via the one or more electrically conductive circuit paths with associated electrical linkage portions 148. In

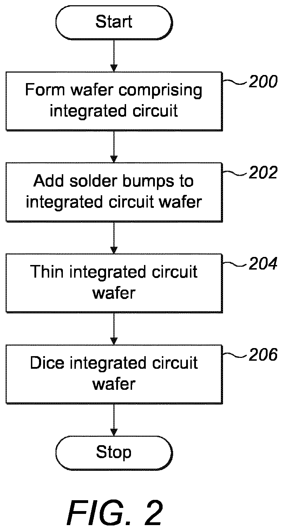

Partial manufacture of the thermal sensor die 102 and the integrated circuit die 104 will now be described with reference to Figures 2 to 6. As some aspects of fabrication of the thermal sensor die 102 and the integrated circuit die 104 are known in the art and not core to the examples described herein, only salient aspects of the construction of the thermal sensor device 100 will be described for the sake of clarity and conciseness of description.

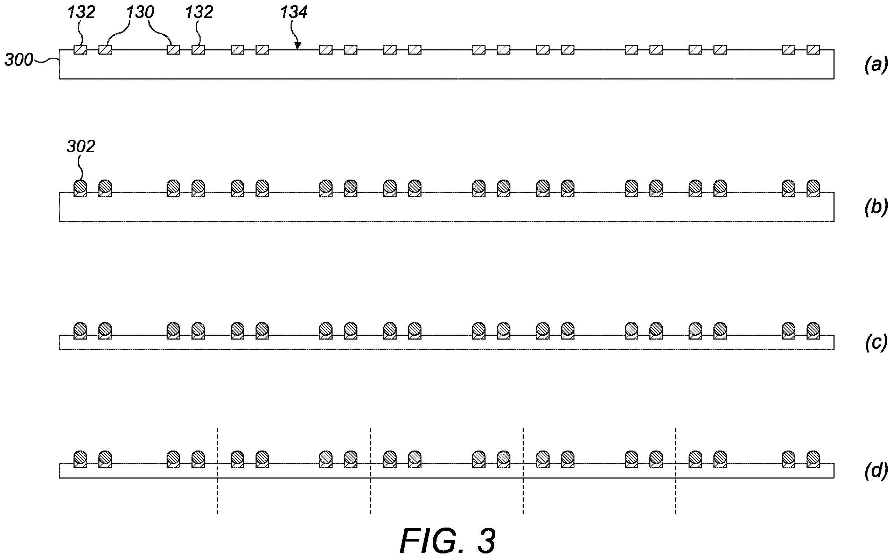

Turning to Figures 2 and 3(a) to (d), an integrated circuit wafer 300 comprising a plurality of integrated circuits (not shown) is fabricated (Step 200) according to any suitable semiconductor fabrication technique known to the skilled person. The second peripheral contact region 130 and the second contact region or regions 132 are formed on the active semiconductor surface 134. The passivation layer 136 (not shown) is also formed over the active semiconductor surface 134 in a manner that leaves the second peripheral contact region 130 and the second contact region or regions 132 exposed. Turning to Figure 3(b), in this example, so called solder pillar bumps 302 formed from, for example a copper/tin alloy, are deposited (Step 202) on the second peripheral contact region 130 and the second contact region or regions 132 using any suitable technique known in the art, for example electroplating. In this example, a continuous pillar bump is formed on the second peripheral contact region 130, for example as a ring shape, in order to ensure a hermetic seal when heated, whereas discrete pillar bumps are formed on the second contact region or regions 132.

Referring to Figure 3(c), thereafter, the wafer 300 is thinned (Step 204), for example to a thickness of between about 100 *µ*m and about 200 *µ*m, and then the wafer 300 is diced (Step 206), as shown in Figure 3(d) in order to form the individual integrated circuit dies 104.

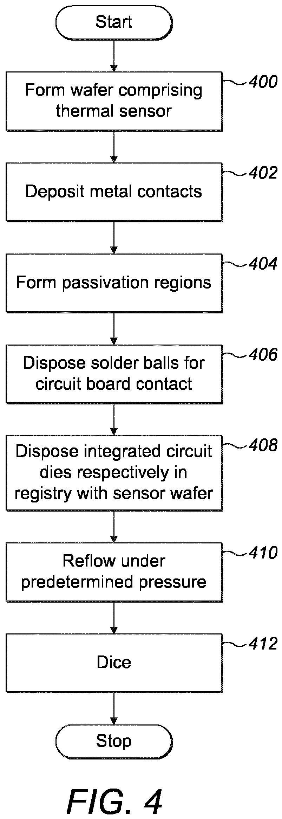

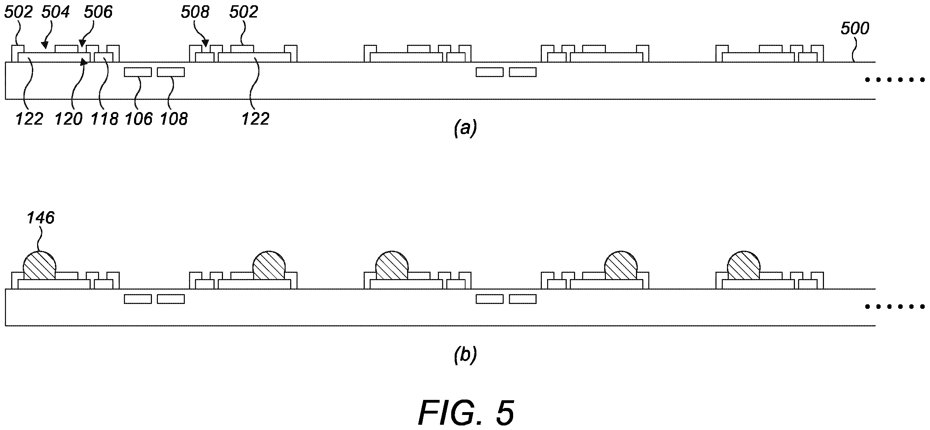

Turning to Figure 4 and Figures 5(a) and 5(b), a thermal sensor wafer 500 is formed (Step 400) so as to comprise the first and second thermal sensors 106, 108 using any suitable fabrication technique known to the skilled person. In the latter stages of fabrication, the first peripheral contact region 118 and the first signal contact region or regions 120 are formed (Step 402) from, in this example, any suitable metal. A second passivation layer 502 is then deposited (Step 404) and patterned so as to provide first apertures 504 proximal the periphery 124 of the thermal sensor die 102 (when diced) on the overhanging portion 144 thereof, the first apertures 504 being provided to receive the electrical linkage portion 148. The second passivation layer 502 is also configured to provide second apertures 506 to expose the first signal contact region or regions 120 and permit electrical contact therewith. The second passivation layer 502 is further configured to provide a third, peripheral, aperture 508 in order to expose the first peripheral contact region 118 for mechanical connection therewith. In this example, once the second passivation layer 502 has been provided, the cavities of 110 of the first and second thermal sensors 106, 108 are etched, thereby protecting the membranes (not shown) of the first and second thermal sensors 106, 108 during preparation of the thermal sensor wafer 500 before proceeding to subsequent processing steps described below. The apertures in the second passivation layer 502 described above serve as second locator apertures for receiving, for example, solder balls therein.

Thereafter (Figure 5(b)), the one or more electrical bridging connections 146, in this example solder balls, are disposed (Step 406) in the first apertures 504 using any suitable technique, for example a so-called "ball drop" sphere placement technique. The solder balls are held in-situ by the material of the second passivation layer 502 surrounding the extending portion of metallisation 122. In other example, craters or recesses in the metallisation 122 can be provided using a solder mask layer in order to snugly receive the one or more electrical bridging connections 146. Once the solder balls 146 have been deposited, the thermal sensor wafer 500 is subjected to reflow processing to wet the solder balls 146 onto thermal sensor wafer 500.

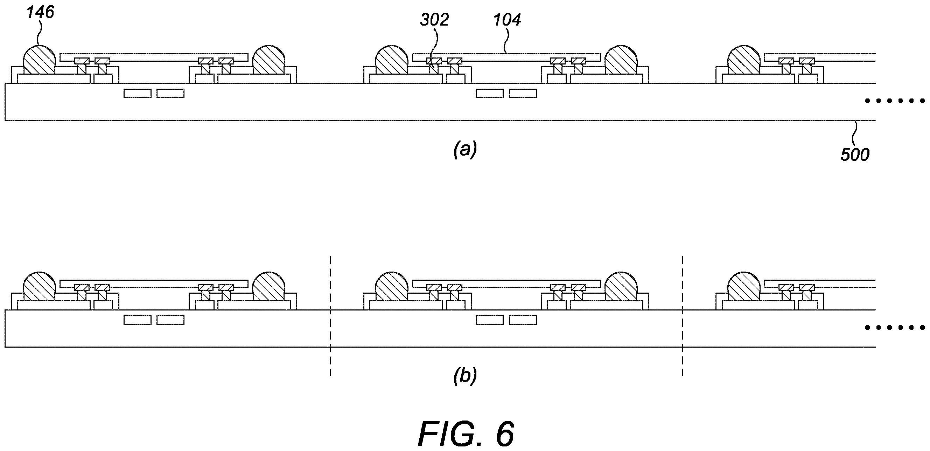

Then, using a "flip chip" (controlled collapse chip connection) technique, the integrated circuit dies 104 are respectively placed in-situ on the sites of the thermal sensor wafer 500 configured to receive the integrated circuit dies 104. The integrated circuit dies 104 are each disposed (Step 408) in registry with a corresponding thermal sensor candidate die of the thermal sensor wafer 500 so that the solder bumps 302 align with the second and third apertures 506, 508 when the device assembly mating side 126 of the integrated circuit die 104 is brought towards the device assembly mating side 114 of the thermal sensor die 104 so as to mate the integrated circuit die 104 with the thermal sensor candidate die of the thermal sensor wafer 500 (Figure 6(a)).

Once the thermal sensor wafer 500 has been populated with the integrated circuit dies 104, the combined assembly is placed in a vacuum oven to undergo a known reflow process (Step 410) in order to melt the solder bumps 302 to form the peripheral wall 140 and hence the chamber 142 that maintains the vacuum local environment, as well as completing the one or more electrical bridging connections 146 between the thermal sensor wafer 500 and the plurality of integrated circuit dies 104.

Once the reflow process has been completed the thermal sensor wafer 500 is diced (Step 412) into individual thermal sensor devices 100.

Although, in the above examples, the electrically conductive circuit path extends from the second contact region or regions 132 to the first signal contact region or regions 120 and then to the extending portion of metallisation 122, which is external to the chamber 142, the contact region or regions of the thermal sensor die 102 and the integrated circuit die 104 can be disposed within the chamber 142. In such an embodiment, the first and second contact region or regions 120, 132 are located within the chamber 142 and the electrically conductive path extends from the second contact region or regions 132, this time within the chamber 142, to the first signal contact region or regions 120 via the one or more respective electrical bridging connections 146 also within the chamber 142. However, instead of the extending portion of metallisation 122 extending over an outer surface of the thermal sensor die 102 on the device assembly mating side 114 thereof, at least a portion of the extending portion of metallisation 122 is buried within the thermal sensor die 102, and electrically isolated from the first peripheral contact region 118, until the extending portion of metallisation 122 extends laterally past the first peripheral contact region 118, whereafter the extending portion of metallisation 122 can return to the surface of the thermal sensor die 102 to provide a coupling surface for the electrical linkage portion 148.

In the examples set forth above, the first passivation layer 136 is provided to prevent out-gassing from materials from which the integrated circuit die 104 is formed. However, in another embodiment, the passivation layer 136 can be replaced or supplemented with a reflective layer configured to reflect infra-red electromagnetic radiation. The reflective layer can be provided below or above the first passivation layer 136.

Additionally, or alternatively, a getter material can be provided, for example a layer thereof disposed at the first device assembly mating side 126 of the integrated circuit die 104.

Although in the above examples, the thermal sensor die 102 comprises substantially parallel surfaces on the device assembly mating side 114 and the scene-ward side 116, the thermal sensor die 102 can possess different profiles, for example steps can be formed in the thermal sensor wafer 500 so that candidate thermal sensor dies 102 each comprise a step. The step can be formed such that the thermal sensor die 102 comprises a T-shape, an outer peripheral region surrounding a region comprising the first and second thermal sensors 106, 108 having been thinned.

## Claims

**1.** A thermal sensor device (100) comprising:
an integrated circuit die (104) having a first device assembly mating side (126) and an external side (128) opposite the device assembly mating side (126);
a sensor-containing die (102) disposed in spaced relation with the integrated circuit die (104) so that the first device assembly mating side (126) of the integrated circuit die (104) faces a second device assembly mating side (114) of the sensor-containing die (102), a portion (144) of the sensor-containing die (102) overhanging the integrated circuit die (104);
an electrically conductive circuit path (132, 146, 120, 122) extending from a first opposing surface (134) of the first device assembly mating side (126) of the integrated circuit die (104) to a second opposing surface of the second device assembly mating side (114) of the sensor-containing die (102) and extending further to the overhanging portion (144) of the sensor-containing die (102) so that a portion of the electrically conductive circuit path (132, 146, 120, 122) also overhangs the integrated circuit die (104); and
an electrical linkage portion (148) electrically coupled to the electrically conductive circuit path (132, 146, 120, 122) at the overhanging portion (144) of the sensor-containing die (102) and extending beyond the external side (128) of the integrated circuit die (104).

**2.** A device as claimed in Claim 1, further comprising:
a continuous sealing layer (140) disposed as a loop and sealingly contacting the first opposing surface (134) and the second opposing surface; wherein
the first and second opposing surfaces (134) together with the continuous sealing layer (140) define an internal volume (142).

**3.** A device as claimed in Claim 2, wherein
the electrically conductive circuit path (132, 146, 120, 122) extends from the first opposing surface (134) to the second opposing surface from within the internal volume (142).

**3.** A device as claimed in Claim 2, wherein the internal volume (142) is pressurised.

**4.** A device as claimed in Claim 1 or Claim 2 or Claim 3, further comprising:
a first passivation layer (136) disposed on the first device assembly mating side (126) of the integrated circuit die (104).

**5.** A device as claimed in Claim 4, wherein the first passivation layer (136) comprises first locator apertures formed therein.

**6.** A device as claimed in Claim 4 or Claim 5, further comprising:
a second passivation layer (502) disposed on the second device assembly mating side (114) of the sensor-containing die (102).

**7.** A device as claimed in Claim 6, wherein the second passivation layer (502) comprises second locator apertures formed therein.

**8.** A device as claimed in any one of Claims 4 to 7, further comprising:
a reflective layer configured to reflect infra-red electromagnetic radiation, the reflective layer being disposed on the first device assembly mating side (126) of the integrated circuit die (104).

**9.** A device as claimed in any one of Claims 4 to 7, further comprising:
a layer of getter material disposed on the first device assembly mating side (126) of the integrated circuit die (104).

**10.** A device as claimed in any one of the preceding claims, wherein the sensor-containing die (102) comprises a lens.

**11.** A device as claimed in any one of the preceding claims, wherein the sensor-containing die comprises an optical filter.

**12.** A device as claimed in any one of the preceding claims, wherein the integrated circuit die (104) is separated from the sensor-containing die (102) by a separation distance, the separation distance being a function of a central wavelength of expected incident infrared electromagnetic radiation.

**13.** A device as claimed in any one of the preceding claims, wherein the sensor-containing die comprises a thermopile thermal sensor element (112) or a microbolometer thermal sensor element.

**14.** A device as claimed in Claim 13, wherein the integrated circuit die (104) comprises an integrated circuit configured to measure a temperature of the thermal sensor element.

**15.** A method of manufacturing a thermal sensor device, the method comprising:
forming (200) an integrated circuit die (104) having a first device assembly mating side (126) and an external side (128) opposite the device assembly mating side (126);
forming (400) a sensor-containing wafer (500) comprising a candidate sensor-containing die (102);
disposing (408) the integrated circuit die (104) opposite the sensor-containing wafer (500) in spaced relation thereto so that the first device assembly mating side (126) of the integrated circuit die (104) faces a second device assembly mating side (114) of the candidate sensor-containing die (102) of the sensor-containing wafer (500), a portion (144) of the candidate sensor-containing die (102) of the sensor-containing wafer (500) overhanging the integrated circuit die (104);
forming (202, 410) an electrically conductive circuit path (132, 146, 120, 122) that extends from a first opposing surface (134) of the first device assembly mating side (126) of the integrated circuit die (104) to a second opposing surface of the second device assembly mating side (114) of the candidate sensor-containing die (102) and extends further to the overhanging portion (144) of the candidate sensor-containing die (102) so that a portion of the electrically conductive circuit path (132, 146, 120, 122) also overhangs the integrated circuit die (104); and
extending (406) the electrically conductive circuit path (132, 146, 120, 122) further by coupling an electrical linkage portion (148) electrically to the overhanging portion (144) of the candidate sensor-containing die (102) so that the electrical linkage portion (148) extends beyond the external side (128) of the integrated circuit die (104).
